# EUROPÄISCHE PATENTSCHRIFT

(11) **EP 0 658 812 B1**
(45) Veröffentlichungstag und Bekanntmachung des Hinweises auf die Patenterteilung: **24.05.2000**
(21) Anmeldenummer: 94115973.3
(22) Anmeldetag: 21.10.1992
(51) Int. Cl.: G03F 7/24, B41C 1/14

(54) **Rotationsbelichtungsmaschine zur Herstellung einer zylindrischen Siebdruckschablone**
Rotating exposure apparatus for the preparation of a cylindrical printing screen
Appareil rotatif pour l'exposition d'un écran de sérigraphie cylindrique

(43) Veröffentlichungstag der Anmeldung: 21.06.1995
(62) Teilanmeldung aus: 92118032.9
(73) Patentinhaber: Schablonentechnik Kufstein Aktiengesellschaft, 6330 Kufstein (AT)
(72) Erfinder: Fischer, Hans, A-6300 Wörgl (AT)
(74) Vertreter: TER MEER STEINMEISTER & PARTNER GbR

(56) Entgegenhaltungen:
- EP-A- 0 291 137
- EP-A- 0 491 368
- WO-A-86/04549
- WO-A-89/11116
- WO-A-90/15714
- DE-C- 3 329 942
- BEITZ, KÜTTNER (HRSGB.) 'Dubbel Taschenbuch für den Maschinenbau', 1986, 15. AUFLAGE, SPRINGER VERLAG, BERLIN * Seite 1011 *

## Beschreibung

Die Erfindung betrifft eine Rotationsbelichtungsmaschine gemäß dem Oberbegriff des Patentanspruchs 1.

Unter Rundform versteht man ein mit Photopolymer beschichtetes Rundsieb oder ein auf ein Trägerrohr aufgezogenes und ebenfalls mit Photopolymer beschichtetes Flachsieb.

Eine derartige Rotationsbelichtungsmaschine ist bereits aus der EP-A-0 291 137 bekannt. Diese bekannte Rotationsbelichtungsmaschine enthält ein Führungsbett, eine sich am Führungsbett abstützende Einrichtung zur drehbaren Lagerung einer Rundform, eine Antriebseinrichtung zur Drehung der Rundform, einen Optikschlitten, der entlang von Führungen bewegt wird, wenn sich die Rundform dreht, und einen Laser zur Belichtung einer auf der Oberfläche der Rundform vorhandenen, photoempfindlichen Lackschicht. wobei der Laser vorn Optikschlitten mitgenommen wird.

Aus der EP-A-0 491 368 ist eine weitere Rotationsbelichtungsmaschine bekannt. Dort ist ebenfalls ein Laser in Zylinderlängsrichtung der Rundform bewegbar, wobei ein den Laser tragender Schlitten jedoch an einer oberhalb der Rotationsbelichtungsmaschine vorhandenen Gebäudedecke befestigt ist.

Eine weitere Rotationsbelichtungsmaschine der genannten Art ist aus der WO-A-86/04549 bekannt. Dort wird ein Laserstrahl über einen auf einem Optikschlitten befindlichen Umlenkspiegel auf eine Rundform gerichtet. wobei der zur Erzeugung des Laserstrahls verwendete Laser auf dem Boden neben der Rotationsbelichtungsmaschine steht.

Aus der WO-A-89/11116 geht noch als bekannt hervor, zur Belichtung bei Rundformen auch einen UV-Laser zu verwenden.

Der Erfindung liegt die Aufgabe zugrunde, die Rotationsbelichtungsmaschine der eingangs genannten Art so weiterzubilden, daß sie einen kompakteren Aufbau aufweist.

Die Lösung der gestellten Aufgabe ist im kennzeichnenden Teil des Patentanspruchs 1 angegeben. Vorteilhafte Ausgestaltungen der Erfindung sind den Unteransprüchen zu entnehmen.

Eine Rotationsbelichtungsmaschine nach der Erfindung zeichnet sich dadurch aus, daß die Führungen am Führungsbett angebracht sind. Dies führt zu einem sehr kompakten und gleichzeitig schwingungsarmen Aufbau, da der Laser relativ nah an der Rundform positioniert werden kann.

Nach einer Ausgestaltung der Erfindung ist der Laserstrahl des Lasers über einen Umlenkspiegel aus der ursprünglich vertikalen Richtung in eine horizontale Richtung umgelenkt und über eine Optik radial auf die Oberfläche der Rundform fokussiert. Dadurch läßt sich der Kompaktheitsgrad der Rotationsbelichtungsmaschine noch weiter erhöhen.

Die Erfindung wird nachfolgend unter Bezugnahme auf die Zeichnung näher beschrieben. Es zeigen:
**Figur 1** eine Rotationsbelichtungsmaschine zur Belichtung einer auf einer Rundform liegenden photoempfindlichen Lackschicht:
**Figur 2** eine Seitenansicht der Rotationsbelichtungsmaschine nach Figur 1:
**Figur 3** eine weitere Rotationsbelichtungsmaschine der genannten Art: und
**Figur 4** eine Seitenansicht der weiteren Belichtungsmaschine nach Figur 3.

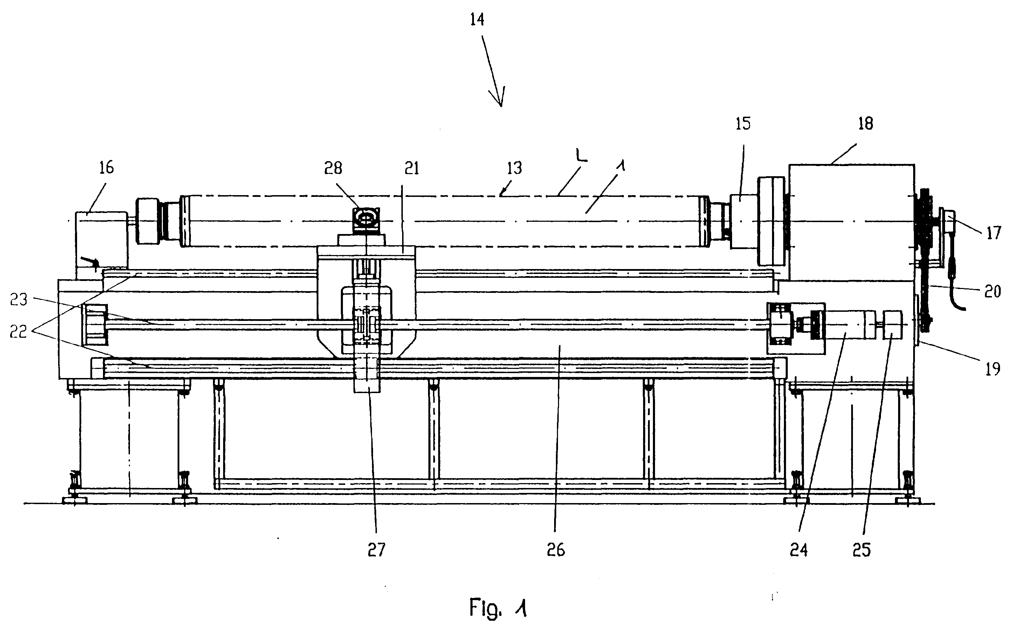

Anhand der Figuren 1 bis 4 werden Rotationsbelichtungsmaschinen zur Belichtung mit Hilfe eines Lasers beschrieben. Durch diesen Laser wird eine zu vernetzende Photopolymerschicht punktweise an den musterbedingt zu vernetzenden Stellen belichtet und damit verfestigt. Diese Stellen bleiben später nach der Entwicklung der Photopolymerschicht stehen.

Eine Rundform 13 wird in eine Rotationsbelichtungsmaschine 14 zwischen ein Spannfutter 15 und einen Reitstock 16 eingelegt. Durch das Schließen des Spannfutters 15 wird mit der Rundform 13 ein Drehlagenencoder 17 drehsteif verbunden. Letzterer ist auf der rechten Seite eines Spindelstocks 18 der Rotationsbelichtungsmaschine 14 angeordnet. Der rotatorische Antrieb der Rundform 13 und der mit dieser verbundenen Anlagenteile erfolgt durch einen Hauptantriebsmotor 19 über einen schwingungsgedämpften Keilriementrieb 20. Während sich die Rundform 13 dreht, wird ein Optikschlitten 21 entlang von Führungen 22 mit Hilfe einer Vorschubspindel 23 und einem mit dieser gekuppelten Schrittmotor 24 bewegt. Am rechten Wellenende des Schrittmotors 24 wird ein Drehschwingungsdämpfer 25 aufgesetzt. Die Führungen 22 und die Vorschubspindel 23 sind an einem Führungsbett 26 der Rotationsbelichtungsmaschine 14 gelagert.

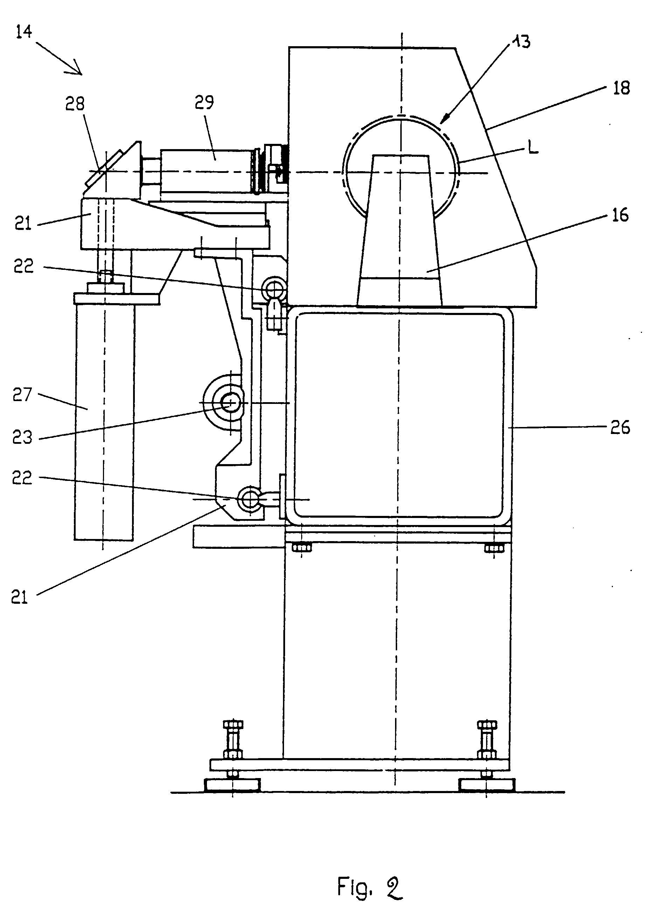

In den Figuren 1 und 2 ist ein mit dem Optikschlitten 21 mitgeführter Argonlaser 27 vorhanden, dessen Laserstrahl über einen Umlenkspiegel 28 aus der ursprünglich vertikalen Richtung in eine horizontale Richtung umgelenkt wird, so daß er dann über eine UV-Optik 29 radial auf die Oberfläche der Rundform 13 fokussiert wird.

Zur Stabilisierung der Schablonenwandung in radialer und tangentialer Richtung können Führungselemente (Rollen. Gleitführungen) vorgesehen werden, jedoch ist dies natürlich nur bei solchen Photopolymeren möglich. welche schon im nicht vernetzten Zustand eine trockene, d. h. feste Oberfläche aufweisen.

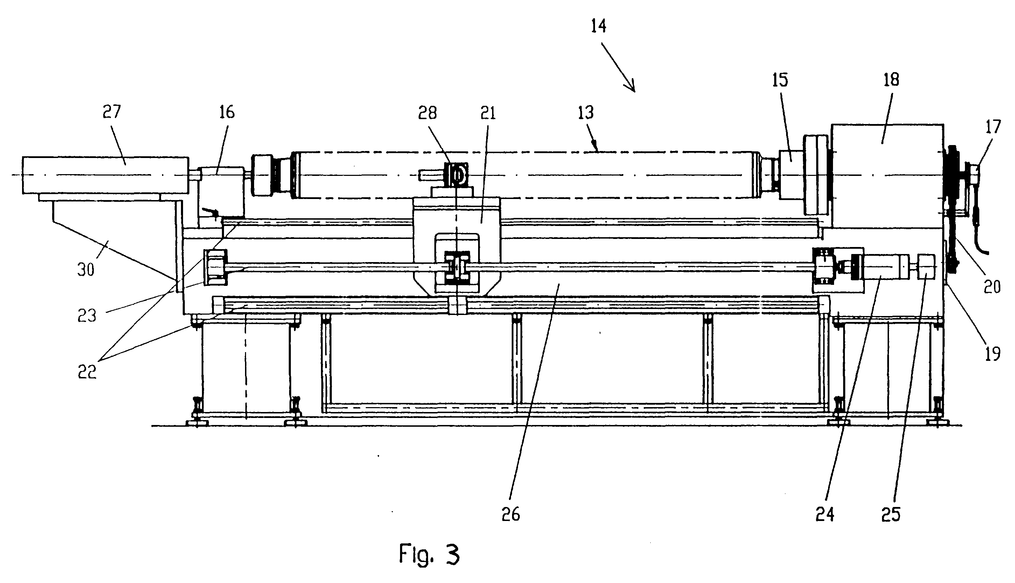

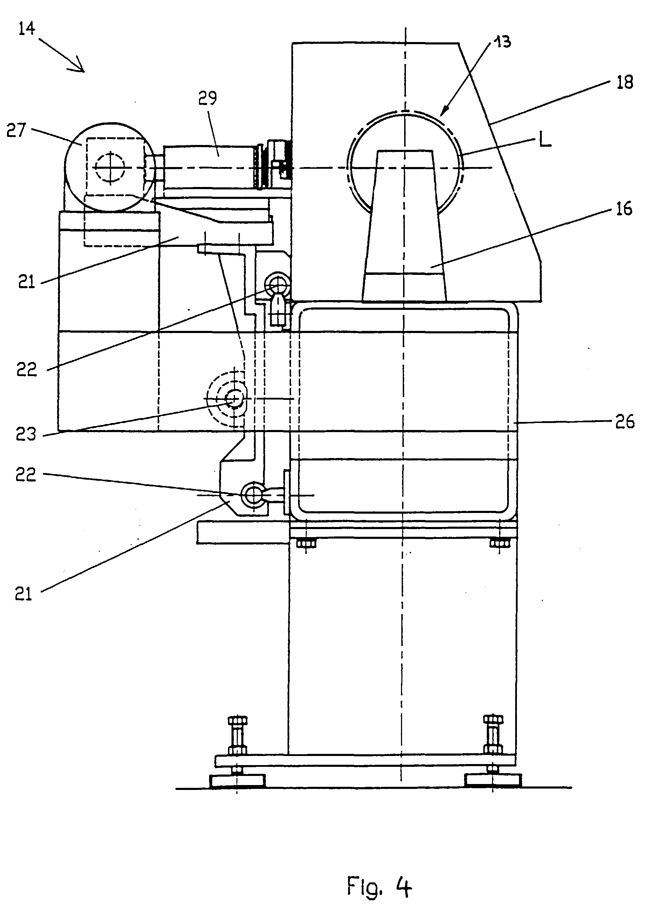

In den Figuren 3 und 4 ist ein ortsfester Argonlaser 27 dargestellt, welcher am reitstockseitigen Ende der Rotationsbelichtungsmaschine 14 über eine Konsole 30 angebracht ist. Anstelle des Argonlasers kann natürlich auch ein anderer im Bereich von 200 bis 400 nm emittierender UV-Laser Verwendung finden, beispielsweise ein Edelgas-Ionen-Laser, ein Farbstoff- oder Excimerenlaser, ein Stickstofflaser, und dergleichen.

Zum Zwecke der punktweisen Belichtung der Oberfläche der Rundform 13 im Fokuspunkt der UV-Optik 29 wird die Laserstrahlung z. B. über einen akustooptischen Modulator ein- oder ausgeschaltet. Für die hier benötigten Zwecke wird man vorzugsweise Quarzglas als Wechselwirkungs- oder Schaltmedium benutzen, da dieses für Licht ab der Wellenlänge von 200 nm durchlässig ist und auch eine ausreichend hohe Schallgeschwindigkeit aufweist, welche für ein hinreichend schnelles Durchschalten des Modulators erforderlich ist. Obwohl am zweckmäßigsten der Strahl 1. Ordnung Verwendung finden wird, also der an den Verdichtungszonen im Wechselwirkungsmedium reflektierte Strahl, weil dadurch ein 0 : 100 - Tastverhältnis der Strahlleistung erreicht werden kann, ist es durchaus aber auch vorstellbar, den Strahl 0. Ordnung für die Oberflächenbelichtung der Rundform 13 heranzuziehen und die dadurch verursachte teilweise Vorvernetzung an den Stellen, die unbelichtet bleiben sollen, in Kauf zu nehmen. Der Entwicklungsprozeß für die Photopolymere, der im wesentlichen in einem Herauslösen der unvernetzten Polymere aus dem Oberflächenfilm besteht, ist durchaus auch in der Lage, teilweise vernetzte Stellen aufzulösen.

## Patentansprüche

1. Rotationsbelichtungsmaschine (14), enthaltend:
- ein Führungsbett (26);
- eine sich am Führungsbett (26) abstützende Einrichtung (15, 16) zur drehbaren Lagerung einer Rundform (13);
- eine Antriebseinrichtung (19, 20) zur Drehung der Rundsform (13);
- einen Optikschlitten (21), der entlang von Führungen (22) bewegt wird, wenn sich die Rundform (13) dreht; und
- einen Laser (27) zur Belichtung einer auf der Oberfläche der Rundform (13) vorhandenen, photoempfindlichen Lackschicht (L) wobei
der Laser (27) vom Optikschlitten (21) mitgeführt wird, **dadurch gekennzeichnet,** daß, die Führungen (22) am Führungsbett (26) angebracht sind.

2. Rotationsbelichtungsmaschine nach Anspruch 1, **dadurch gekennzeichnet,** daß ein Laserstrahl des Lasers (27) über einen Umlenkspiegel (28) aus der ursprünglich vertikalen Richtung in eine horizontale Richtung umgelenkt und über eine Optik (29) radial auf die Oberfläche der Rundform (13) fokussiert wird.

3. Rotationsbelichtungsmaschine nach Anspruch 1 oder 2, **dadurch gekennzeichnet,** daß der Laser (27) ein im Bereich von 200 nm bis 400 nm emittierender UV-Laser ist.

4. Rotationsbelichtungsmaschine nach einem der Ansprüche 1 bis 3, **dadurch gekennzeichnet,** daß der Optikschlitten (21) mit Hilfe einer Vorschubspindel (23) bewegt wird.

5. Rotationsbelichtungsmaschine nach Anspruch 4, **dadurch gekennzeichnet,** daß mit der Vorschubspindel (23) ein Schrittmotor (24) gekuppelt ist.

6. Rotationsbelichtungsmaschine nach Anspruch 5, **dadurch gekennzeichnet,** daß auf das freie Ende des Schrittmotors (24) ein Drehschwingungsdämpfer (25) aufgesetzt ist.

## Claims

1. Rotary exposure machine (14), containing:
- a guide bed (26) ;
- a device (15, 16), supported on the guide bed (26), for the rotable mounting of a round mould (13);
- a drive device (19, 20) for rotating the round mould (13);
- an optical slide (21) which is moved along guides (22) as the round mould (13) rotates; and
- a laser (27) for exposing a photosensitive lacquer layer (L) which is present on the surface of the round mould (13), the laser (27) being carried along by the optical slide (21),
characterized in that the guides (22) are fitted to the guide bed (26).

2. Rotary exposure machine according to Claim 1, characterized in that a laser beam from the laser (27) is deflected by a deflection mirror (28) from the originally vertical direction into a horizontal direction, and is focused radially by an optical system (29) onto the surface of the round mould (13).

3. Rotary exposure machine according to Claim 1 or 2, characterized in that the laser (27) is an UV laser emitting in the range from 200 nm to 400 nm.

4. Rotary exposure machine according to one of Claims 1 to 3, characterized in that the optical slide (21) is moved with the aid of a feed screw (23).

5. Rotary exposure machine according to Claim 4, characterized in that a stepping motor (24) is coupled to the feed screw (23).

6. Rotary exposure machine according to Claim 5, characterized in that a torsional-vibration damper (25) is mounted on the free end of the stepping motor (24).

## Revendications

1. Appareil rotatif d'insolation (14), comprenant :
- un banc de guidage (26) ;
- un dispositif (15, 16) s'appuyant sur le banc de guidage pour le montage en rotation d'une forme ronde (13) ;
- un dispositif d'entraînement (19, 20) pour l'entraînement en rotation de la forme ronde (13) ;
- un chariot optique (21), qui est déplacé le long de guidages (22), lorsque la forme ronde (13) est entraînée en rotation ; et
- un laser (27) pour l'éclairage de la couche de vernis photosensible (L) présente sur la surface de la forme ronde (13), de sorte que le laser (27) soit entraîné par le chariot optique (21),
caractérisé en ce que les guidages (22) sont montés sur le banc de guidage (26).

2. Appareil rotatif d'insolation selon la revendication 1, caractérisée en ce qu'un faisceau laser du laser (27) est dévié sur un miroir de renvoi (28) de sa direction verticale d'origine dans une direction horizontale et est focalisé par une optique (29) radialement sur la surface de la forme ronde (13).

3. Appareil rotatif d'insolation selon la revendication 1 ou 2, caractérisée en ce que le laser (27) est un laser U.V. émettant dans la bande comprise entre 200 nm et 400 nm.

4. Appareil rotatif d'insolation selon l'une des revendications 1 à 3, caractérisée en ce que le chariot optique (21) est déplacé par l'intermédiaire d'une broche d'avance (23).

5. Appareil rotatif d'insolation selon la revendication 4, caractérisée en ce qu'un moteur pas à pas (24) est accouplé à la broche d'avance (23).

6. Appareil rotatif d'insolation selon la revendication 5, caractérisée en ce qu'à l'extrémité libre du moteur pas à pas (24), est monté un amortisseur de vibrations de torsion (25).
